# EUROPÄISCHE PATENTSCHRIFT

(11) **EP 1 738 461 B1**
(45) Veröffentlichungstag und Bekanntmachung des Hinweises auf die Patenterteilung: **22.08.2007**
(21) Anmeldenummer: 05737756.6
(22) Anmeldetag: 14.04.2005
(51) Int. Cl.: H03K 17/96

(54) **BEDIENEINRICHTUNG MIT EINEM BERÜHRUNGSSCHALTER**
OPERATIONAL UNIT COMPRISING A TOUCH-SENSITIVE SWITCH
DISPOSITIF DE COMMANDE COMPRENANT UN COMMUTATEUR DE CONTACT

(30) Priorität: 15.04.2004 DE 102004019304
(43) Veröffentlichungstag der Anmeldung: 03.01.2007
(73) Patentinhaber: E.G.O. Control Systems GmbH, 72336 Balingen-Frommern (DE)
(72) Erfinder: WEISS, Josef, 78586 Deilingen (DE); BAYER, Ewald, 72858 Dormettingen (DE)
(74) Vertreter: Patentanwälte Ruff, Wilhelm, Beier, Dauster & Partner
(86) Internationale Anmeldenummer: PCT/EP2005/003943
(87) Internationale Veröffentlichungsnummer: WO 2005/101663

(56) Entgegenhaltungen:
- EP-A- 0 859 467
- US-A1- 2002 167 704
- US-B1- 6 403 904

## Beschreibung

Die Erfindung betrifft eine Bedieneinrichtung zur Bedienung eines Elektrogerätes mit einem Näherungs- oder Berührungsschalter, nach dem Oberbegriff des Anspruchs 1.

Berührungs- oder Touch-Schalter sind aus der EP 859 467 A1 bekannt. Bei ihnen wird die Berührfläche, deren Berührung oder Annäherung durch eine Elektronik zum Schaltvorgang ausgewertet wird, durch ein unter einer Abdeckung liegendes Sensor-Element bestimmt, die aus einem elektrisch leitfähigen flexiblen Material, beispielsweise einem gummiartigen Kunststoff oder Schaumstoff besteht. Dadurch wird die Unterseite der Abdeckung gut kontaktiert und sorgt für konstante Bedingungen. Zur Signalisierung der durchgeführten Schaltung ist dabei eine Leuchtdiode vorgesehen, die in der Mitte des kreisringförmigen Sensor-Elementes auf der Leiterplatte, die das Sensor-Element trägt, angeordnet ist und durch die transparente Abdeckung, beispielsweise eine Glaskeramikplatte, durchleuchtet.

Aus der US 6,403,904 B1 ist ein Sensorelement einer Bedieneinrichtung eines Elektrogerätes bekannt, welches mit einem Leucht-Element in der Nähe des Schaltbereichs ausgestattet ist. Das Sensor-Element wird durch eine elektrische leitfähige Fläche gebildet, die auf eine Sieben-Segment-Anzeige bzw. deren Gehäuseoberseite aufgesetzt ist.

### Aufgabe und Lösung

Aufgabe der Erfindung ist es, eine solche Bedieneinrichtung so zu gestalten, dass sie bei den unterschiedlichsten Arten von Abdeckungen auch unter extremen Umweltbedingungen größtmögliche Sicherheit für den Bedienenden gewährleistet.

Diese Aufgabe wird gemäß der Erfindung durch den Anspruch 1 gelöst.

Bei der Erfindung kann, z.B. bei einer nichttransparenten Abdeckung, wie einer aus eingefärbtem Kunststoff bestehenden Blende eines Wäschetrockners, ein Leucht-Element zur Signalisierung des Einschaltvorganges im Sinn zur Tastenbereich durch einen Durchbruch der Abdeckung hindurchragen. Selbst wenn das Leucht-Element ideal eingepasst ist, können geringfügige Spalte entstehen, durch die beispielsweise Wasser dringen kann. Die von den Vorschriften geforderte Luft- und Kriechstrecke zwischen einem berührbaren Teil und einem spannungsführenden Teil, die normalerweise 12mm betragen muss, wäre dann nicht eingehalten. Die elektrisch isolierende Ummantelung des Sensor- oder Leucht-Elementes an seinem Umfang schafft diese Kriechstrecke, ohne die Wirkung des elektrisch leitfähigen Sensor-Elementes zu beeinträchtigen.

Besonders vorteilhaft kann das Sensor-Element zweiteilig ausgebildet sein. Der eine Teil kann auf dem entsprechenden Kontakt der Leiterplatte liegen und der andere Teil die Abdeckung kontaktieren. Zwischen beiden kann eine elektrische Isolation vorgesehen sein, so dass der an die Abdeckung angrenzende Teil galvanisch von dem spannungsführenden, an der Leiterplatte anliegenden Teil getrennt ist. Es hat sich jedoch gezeigt, dass die Wirksamkeit und die steuerungsmäßige Ankopplung des Sensor-Elementes an den Schaltkreis des Berührungsschalters nicht beeinträchtigt wird. Die Zweiteilung macht es auch besonders leicht, die beiden Stirnflächen des Sensor-Elementes unterschiedlich groß zu machen, so dass eine kleinere Stirnfläche auf der Leiterplatte wenig Platz beansprucht, während die größere Stirnfläche des an der Abdeckung anliegenden Teils eine komfortable Größe des Schaltbereichs sicherstellt.

Der Bedienungsfreundlichkeit dient es, wenn das Leucht-Element in die Berührfläche integriert ist und beispielsweise durch das Sensor-Element, und zwar besonders einen abdeckungsnahen Teil, hindurchragt. Dadurch umgibt der Schaltbereich auf der Berührfläche das Leucht-Element. Besonders bevorzugt ist, wenn das Leucht-Element exzentrisch zum Schaltbereich angeordnet ist, weil dann der Bedienende dieses bei dem Schaltvorgang nicht automatisch abdeckt.

Das Sensor-Element, vorzugsweise sein abdeckungsnaher Teil, kann als Dichtung für den Durchbruch ausgebildet sein. Dies ist besonders dann wirksam, wenn dieser Sensor-Elemententeil an seiner Abdeckung kontaktierenden Stirnfläche eine geschlossene Oberfläche hat, beispielsweise als flexibler, aber doch massiver gummiartiger Kunststoff ausgebildet ist oder als Schaumstoff mit geschlossenporiger Oberfläche.

All diese Vorteile werden besonders gut durch ein Aufnahmeelement verwirklicht, das eine zur Ummantelung gehörende, vorzugsweise topfförmige Aufnahme für den auflagenahen Teil des Sensor-Elementes hat. Deren Boden bildet die Isolation und trägt auf der anderen Seite eine etwa schalenförmige Aufnahme für den abdeckungsnahen Teil des Sensor-Elementes, der relativ flach, ähnlich einer Scheibe ausgebildet sein kann. Diese Aufnahme kann im Grunde kreiszylindrisch sein, wobei jedoch die schalenförmige Aufnahme für den abdeckungsnahen Teil einen größeren Durchmesser hat als die der Leiterplatte zugewandte Aufnahme. Dadurch ergibt sich auch eine abgesetzte Außenfläche des Aufnahmeelementes, wodurch die geforderte Luft- und Kriechstrecke eingehalten werden kann, ohne dass der Abstand zwischen Auflage (Leiterplatte) und Abdeckung zu groß werden muss.

Das Aufnahmeelement kann aus transparentem Kunststoffspritzguss hergestellt sein und somit einen Lichtleiter bilden, bei dem ein durch die schalenförmige Aufnahme hindurchragender Vorsprung, der den Mantel der topfförmigen Aufnahme verlängert, eine durchgehende Lichtleiterbahn zwischen einem auf der Leiterplatte angeordneten Lichterzeuger, beispielsweise einer Leuchtdiode (LED) und der durch den Durchbruch ragenden Lichtaustrittsfläche des Leuchtelementes bildet.

Die sich zwischen den beiden Aufnahmen aufgrund der unterschiedlichen Durchmesser bildende Stufe kann durch eine beispielsweise den halben Umfang des Aufnahmeelementes umgebende Rippe vergrößert sein, die neben ihrer die Luft- und Kriechstrecke vergrößernden Wirkung auch eine Tropfnase für in unglücklichsten Fällen eingedrungene Feuchtigkeit bildet, die somit die Leiterplatte nicht erreicht.

Besonders bevorzugt wird also ein Berührungsschalter geschaffen, dessen elektrischer Schaltkreis auf einer Leiterplatte vorgesehen ist. Er ist über ein Sensor-Element an einen Berührungs-Schaltbereich auf einer Blende oder Abdeckung eines Elektrogerätes angekoppelt. Das Sensor-Element kann zweiteilig sein und aus einem flexiblen, elektrisch leitenden Kunststoff- oder Schaumstoffmaterial bestehen. Die beiden Teile des Sensor-Elementes sind in einem Aufnahmeelement oder -käfig aus elektrisch isolierendem, transparenten Kunststoff aufgenommen, der mit einer Zwischenwand die beiden Sensor-Elemententeilevoneinander elektrisch isoliert und außen ummantelt, so dass zwischen spannungsführenden Teilen angrenzend an die Leiterplatte und einem Durchbruch in der Blende eine ausreichende Luft- und Kriechstrecke ragt ein Leuchtelement, das durch das auf die Funktion eines Lichtleiters erfüllende Aufnahmeelement hindurch von einer LED auf der Leiterplatte beleuchtet wird.

Alternativ kann das Leucht-Element von der Ummantelung umgeben sein und diese kann unmittelbar an den Durchbruch anschließen, so dass sie die Luft- und Kriechstrecke bildet. Günstig ist, wenn das Sensor-Element die rohrförmig ausgebildete Ummantelung umgibt und sozusagen auf diese aufgesteckt ist. Bei einem exzentrisch zur Schaltfläche liegenden Durchbruch kann die Ummantelung den Außenumfang des Sensor-Elementes tangieren oder stützen und somit ebenfalls zur Lagerung des Sensor-Elementes beitragen.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird.

### Kurzbeschreibung der Zeichnungen

Ausführungsbeispiele der Erfindung sind in der Zeichnung schematisch dargestellt und werden im folgenden näher erläutert. Es zeigen:
- Fig. 1: eine schematische Draufsicht auf eine Abdeckung oder Blende eines Elektrogerätes,
- Fig. 2: ein Längsschnitt durch ein Teil einer Bedieneinrichtung,
- Fig. 3: einen Schnitt nach der Linie III-III in Fig. 2,
- Fig. 4: eine Draufsicht auf eine Bedieneinrichtung mit Berührungsschalter,
- Fig. 5: einen Teil-Querschnitt durch Abdeckung und Berührungsschalter nach Fig. 4,
- Fig. 6: eine Draufsicht entsprechend Figur 4 mit einem exzentrisch zum Schaltbereich liegenden Durchbruch,
- Fig. 7: einen Schnitt durch ein Detail des Berührungsschalters und
- Fig. 8: eine Ansicht gemäß dem Pfeil VIII in Figur 7, ohne Leiterplatte.

### Beschreibung des Ausführungsbeispiels

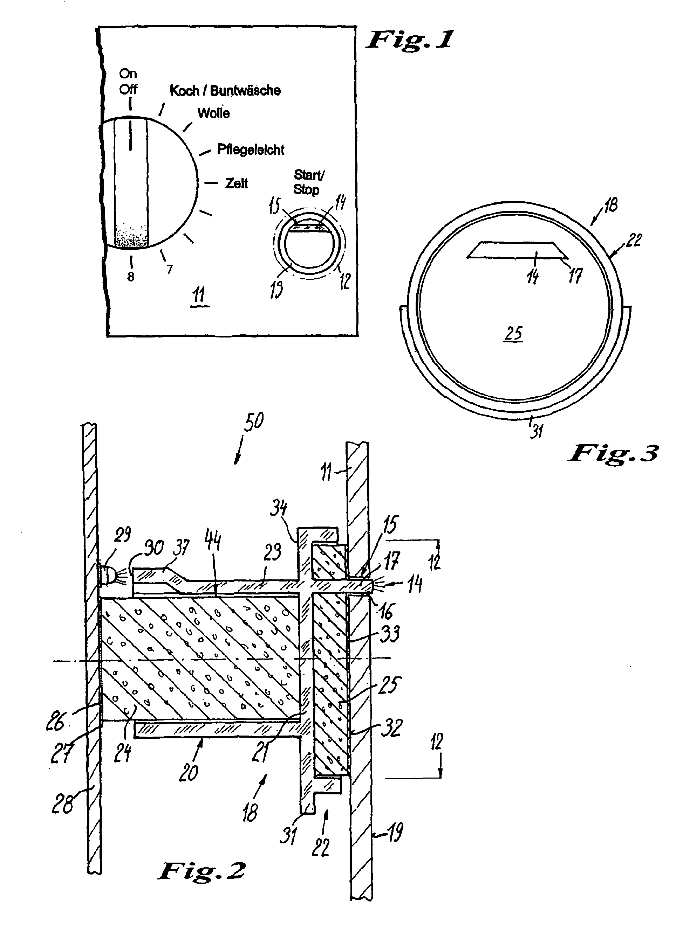

Fig. 1 zeigt eine Frontansicht einer Abdeckung 11, die die Blende des Bedienungsteils eines Wäschetrockners bildet. Auf ihr ist neben anderen Einstellorganen, z.B. als "Start/Stop"-Taste, der Schaltbereich 12 eines Näherungs- oder Berührungsschalters 50 abgegrenzt und durch eine Markierung 13 gekennzeichnet, z.B. durch entsprechende Bedruckung oder plastische Hervorhebung. Die Abdeckung besteht aus einem opaken, also nicht durchscheinenden Kunststoff oder anderem nicht durchscheinendem Material.

Im Schaltbereich ist die Lichtaustrittsfläche 14 eines Leucht-Elementes 15 zu erkennen, die zwar innerhalb des Schaltbereiches 12, jedoch exzentrisch zu diesem liegt, im vorliegenden Falle nach oben versetzt.

Fig. 2 zeigt im Längsschnitt die Abdeckung 11, die an der Stelle des Leucht-Elementes 15 einen Durchbruch 16 aufweist, in dem das Leuchtelement in Form eines im Ausführungsbeispiel trapezförmigen Vorsprunges 17 eines Aufnahmeelementes 18 eingreift, so dass die Lichtaustrittsfläche 14 im wesentlichen in einer Ebene mit der Außenfläche 19 der Abdeckung 11 abschließt.

Das Aufnahmeelement 18 besteht aus elektrisch nicht leitendem Material, meist transparentem Kunststoff-Spritzguss, und enthält zwei kreiszylindrische Abschnitte unterschiedlichen Durchmessers, von denen einer eine Aufnahme 20 bildet, die etwa topfförmig ist. Ihr Boden 21 bildet gleichzeitig den Boden einer entgegengesetzt gerichteten Aufnahme 22, die einen größeren Durchmesser hat als die Aufnahme 20 und wesentlich flacher, also eher schalenförmig ist. Der die beiden Aufnahmen voneinander trennende Boden 21 ist über den halben Umfang (siehe Fig. 3) vorstehend verlängert, so dass er eine halbkreisförmige Rippe 31 bildet.

Der Vorsprung 70 durchquert die schalenförmige Aufnahme 22 und liegt in Verlängerung der Wandung der Aufnahme 20, die eine Ummantelung 23 für ein Teil 24 eines Sensor-Elementes 44 bildet, dessen anderes Teil 25 in der Aufnahme 22 liegt.

Diese Sensor-Elemententeile 24, 25 bestehen aus einem elektrisch leitfähigen, flexiblen Kunststoff, Kunststoffschaum oder Gummi, wie er in der EP 0 859 467 A1 beschrieben ist und der auch als Leitgummi bezeichnet wird. Auf die EP 0 859 467 A1 wird zum Zweck der Offenbarung ausdrücklich Bezug genommen, ebenso zur Funktion des Berührungsschalters.

Die aus der Aufnahme 20 herausragende Stirnfläche 26 liegt an einer Kontaktfläche 27 an, die auf einer eine Auflage 28 bildenden Leiterplatte vorgesehen ist. Die Leiterplatte trägt in üblicher Weise eine gedruckte Schaltung, die auch die Kontaktfläche 27 umfasst und enthält die aktiven und passiven Bauteile sowie die Leiterbahnen des Berührungsschalters, gegebenenfalls auch mehrere Berührungsschalter und anderer Steuer- und Regeleinheiten für das Elektrogerät. Auf der Leiterplatte ist auch eine Leuchtdiode (LED) 29 angeordnet, die angrenzend an die äußere, in Fig. 2 linke Stirnfläche 30 der Ummantelung 23 angeordnet ist, die an dieser Stelle eine Ausbuchtung 37 nach außen aufweist, um einen Abstand der Diode von dem Sensor-Element sicherzustellen.

Der in der Aufnahme 20 liegende, der Leiterplatte zugekehrte Sensor-Elementteil 24 hat die Form eines relativ langgestreckten Kreiszylinders und ragt einiges über die Stirnfläche hinaus, also aus der Aufnahme 20 heraus. Er kann aus flexiblerem elektrisch leitfähigen Material sein, beispielsweise Schaumstoff.

Der in der Aufnahme 22 liegende Sensor-Elemententeil25 hat die Form einer etwas dickeren Kreisscheibe und besteht aus einem Material, das entweder massiv, aber weichelastisch ist oder aus einem Schaumstoff bestehen kann, der auf seiner an die Abdeckung 11 anliegenden Stirnfläche 32 geschlossen ist, beispielsweise durch eine Haut 33, wie sie beispielsweise bei Integralschäumen entsteht. Auch der Sensor-Elemententeil25 ragt etwas über die Außenwandung der Aufnahme 22 hinaus und bietet daher eine Flexibilitätsreserve. Der Vorsprung 17 ragt durch eine entsprechend geformte Öffnung im Sensor-Elemententeil 25 hindurch. Er wird also von Abschnitten dieses Sensor-Elementteils 25 umgeben, so dass die Lichtaustrittsfläche 14 etwas innerhalb des Schaltbereiches 12 liegt, der im wesentlichen von dem Sensor-Elemententeil 25 bestimmt ist.

### Funktion

Das Aufnahmeelement 18 wird mit den Sensorelemententeilen 24, 25 bestückt und zwischen die Auflage 28 und die Abdeckung 11 eingebracht, indem der Vorsprung 17 passend in den Durchbruch 16 eingesetzt wird. Dadurch bildet sich auch eine formschlüssige mechanische Festlegung der Sensor-Elementeinheit an der Abdeckung. Zur Bestückung ist es auch möglich, das oder die Sensor-Elemente mit der Leiterplatte 28 der Abdeckung 11 und/oder dem Aufnahmeelement 18 durch einen, gegebenenfalls elektrisch leitenden Haftkleber zu verbinden.

Zur Positionierung ist noch zu bemerken, dass infolge der Zweiteilung des Sensor-Elementenkörpers in einem längeren Teil 24 mit geringerem Durchmesser und einem kurzen Teil 25 mit größerem Durchmesser einerseits bei einem großen Schaltbereich 12 die auf der Leiterplatte notwendige Kontaktfläche 26, 27 kleiner sein kann. Andererseits ist es möglich, die durch die Elastizität der Sensor-Elemente zu erreichende Unabhängigkeit vom genauen Abstand bei ausreichendem Anpressdruck zwischen Abdeckung 11 und Auflage 28 zu erreichen, ohne dass die genaue Ausrichtung der Lichtaustrittsfläche 14 mit der Außenfläche 19 der Abdeckung behindert ist. Dementsprechend kann das Sensor-Elemententeil 25 aus einem Material mit geringerer Elastizität bestehen, während die Hauptverformung im Bereich des längeren Sensor-Elemententeils 44 vorgenommen wird. Dort wird auch der Hauptanteil der Elastizitätsreserve gespeichert, die für ein gleichmäßiges und sattes Anliegen der Sensor-Elemente an Abdeckung, Auflage und am Boden 21 sorgt.

Durch die Ummantelung 23 der Aufnahmen 20 und 22 und auch die sich dazwischen bildende Stufe 34, die aus einem elektrisch nicht leitenden Material bestehen, wird eine äußere elektrische Isolierung der Sensor-Elementes 44 geschaffen und auch die beiden Sensor-Elemententeile 24, 25 sind galvanisch voneinander isoliert. Dementsprechend bildet sich auch zwischen der Leiterplatte bzw. dem aus der Aufnahme 20 herausragenden Teil des Sensor-Elementes 44 und dem Durchbruch 16 bzw. dem aus der Aufnahme 22 herausragenden Abschnitt des Sensor-Elemententeils 44 eine Luft- und Kriechstrecke, die mindestens 12mm beträgt, ohne dass der Abstand zwischen Leiterplatte und Abdeckung größer sein muss. Die beiden Sensor-Elemententeil 44 sind auf unterschiedlich elektrischem Potential. Während der Teil 24, der die Leiterplatte kontaktiert und dort z.B. zu einem elektrischen Schwingkreis gehört, spannungsführend sein kann, ist der Teil 25 elektrisch nicht angeschlossen, sondern durch den Boden 21 davon isoliert. Es hat sich gezeigt, dass dennoch die Funktion des Berührungsschalters nicht leidet, da bei kapazitiven Berührungsschaltern diese Sensor-Elemente Teile eines Kondensators sind und ja ohnehin durch die Abdeckung elektrisch von dem betätigenden Finger isoliert sind.

Der Querschnitt der Sensor-Elemente, der hier als kreisförmig beschrieben wurde, kann auch beliebige andere, insbesondere auch der Tastenform angepasste Gestalt haben. Das gleiche gilt für das Leuchtelement, das mit trapezförmigem Querschnitt gezeigt ist.

Das Aufnahmeelement hat also eine Mehrfach-Funktion. Es dient einerseits zur mechanischen und elektrischen Trennung zweier Sensor-Elemente, gleichzeitig aber zu ihrem Zusammenhalt und zu ihrer elektrischen Isolierung sowie zur Schaffung einer Luft- und Kriechstrecke. Ferner dient es als Lichtleiter für das Leucht-Element und als Dichtung für den Durchbruch 16, um Eindringen von Feuchtigkeit in das Innere zu vermeiden. Es ermöglicht auch eine Funktionstrennung zwischen den beiden Sensor-Elemententeilen und die Verwendung unterschiedlicher Werkstoffe dafür um die Positionierung des Leucht-Elementes an bzw. in der Blende 11 sicherzustellen.

### Weitere Ausführungsbeispiele

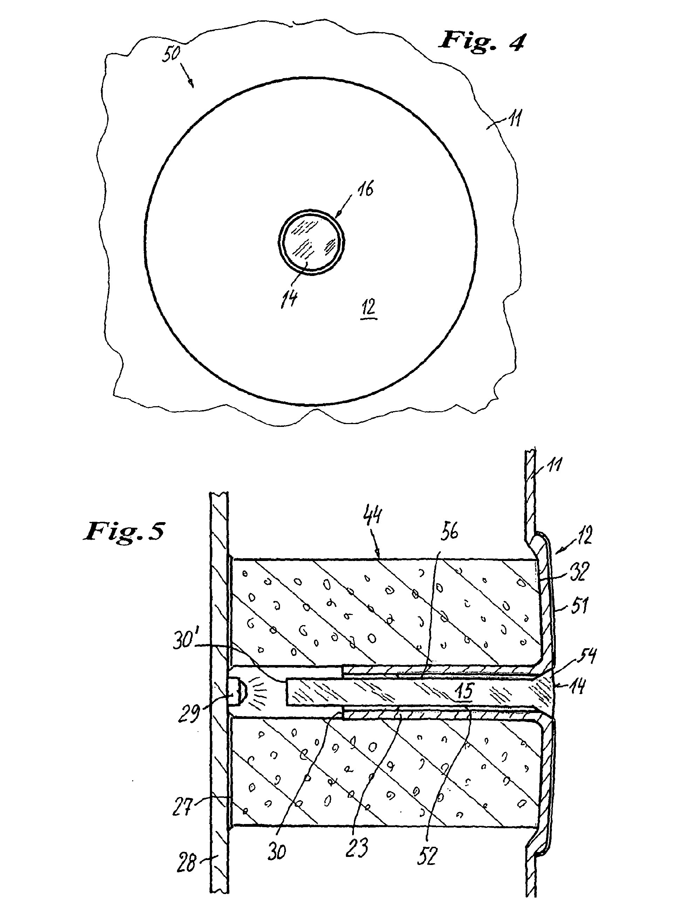

Figur 4 und 5 zeigen einen Berührungsschalter 50, der einen kreisrunden Schaltbereich 12 aufweist, der an einer Abdeckung 11 abgegrenzt ist. Figur 5 zeigt, dass der Schaltbereich 12 als ggf. leicht ballige Erhöhung der Abdeckung 11 in diese eingeformt ist. Er kann zusätzlich mit einer beispielsweise metallischen Abdeckung oder Beschichtung 51 versehen sein, die ihn von der Umgebung abhebt.

In der Mitte des Schaltbereiches 12 ist ein Durchbruch 16 in die Abdeckung eingeformt. Dieser setzt sich in einem Innenkanal 52 fort, der innerhalb einer rohrförmigen Ummantelung 23 ausgebildet ist, die innen an der Abdeckung 11 angeformt, also mit dieser einteilig verbunden ist.

Ein Leucht-Element 15 ist in den rohrförmigen Aufnahmekanal eingesteckt. Es besteht aus glasklarem Kunststoff und ist stiftförmig mit geringerem Durchmesser als der Aufnahmekanal 52 ausgebildet, so dass von einem Luftspalt 53 umgeben ist. Innere Rippen zentrieren das Leucht-Element 15. Das Leucht-Element hat einen Kopf 54 ähnlich dem eines Nagels, dessen Kopffläche die Lichtaustrittsfläche 14 bildet. Der Kopf 54 liegt in einer Ansenkung des Durchbruchs und kann ggf. von einer nicht dargestellten Dichtung unterlegt sein. Befestigt wird das Leucht-Element durch Klemmen, Einschnappen mittels nicht dargestellter Rastelemente oder durch Einkleben. Die Ummantelung 23 ist bis zu ihrer unteren Stirnfläche 30 ununterbrochen und so lang, wie die gewünschte oder erforderliche Luft- und Kriechstrecken, d. h. mehr als 12 mm.

Auf die rohrförmige Ummantelung 23 ist das ebenfalls rohrförmige Sensor-Element 44 aufgesteckt. Es liegt mit seiner oberen Stirnfläche 32 im Schaltbereich also an der Unterseite der Abdeckung 11 an, die dort entsprechend der äußeren Erhöhung des Schaltbereiches etwas vertieft ist. Die rohrförmige Ummantelung trägt und führt also das infolge seiner Elastizität sich gut darauf haltende Sensor-Element. Es ragt über die Ummantelung 23 hinaus und liegt, wie anhand von Figur 2 beschrieben auf der in diesem Fall ringförmigen Kontaktfläche 27 der Leiterplatte 28 auf. In der Mitte dieser Kontaktfläche ist die Leuchtdiode 29 vorgesehen, die somit der Lichteintrittsfläche 30' des Leucht-Elementes gegenüberliegt. Dieses wirkt als Lichtleiter für den Austritt von Licht aus der Lichtaustrittsfläche 14.

Es ist zu erkennen, dass hier eine besonders einfache und wirksame Möglichkeit geschaffen ist, eine in einem Durchbruch einer Abdeckung eingefügte Lichtaustrittsfläche mit Lichtleiter zu schaffen, die einerseits dicht eingefügt werden kann und andererseits auch die für den Notfall vorgesehene Luft- und Kriechstrecke schafft, und zwar zwischen der ersten Berührungsmöglichkeit durch einen Bedienenden (Außenseite des Schaltbereiches) und dem elektrisch leitenden Sensorelement 44, also dem Bereich nahe der Stirnfläche 30.

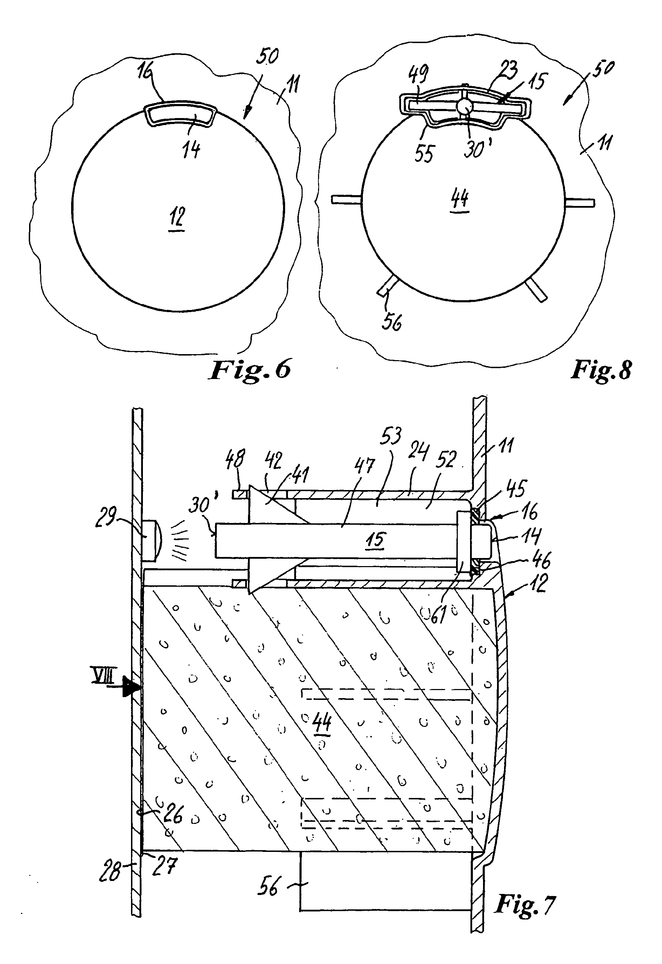

Die Figuren 6 bis 8 zeigen eine Ausführungsform, bei der der ebenfalls in die Abdeckung 11 eingeformte Schaltbereich 12 auch kreisrund ist, jedoch einen Durchbruch 16 enthält, der zwar innerhalb der Kreisfläche, jedoch an deren Rand in Form eines Kreisringsegmentes ausgebildet ist. Dementsprechend ist auch die Lichtaustrittsfläche 14 des darin sitzenden Leucht-Elementes 15 kreisring-segmentförmig.

Figur 7 zeigt, dass der Durchbruch 16 in einer Ausnehmung der etwas erhöhten Schaltfläche 12 der Abdeckung 11 ausgebildet ist. Durch den Durchbruch 16 ragt der Lichtleiter hindurch, der in Form eines flachen bzw. gebogenen Stiftes ausgebildet ist. Die Austrittsfläche 14 ragt durch den Durchbruch, aber keinesfalls über die Schaltfläche 12 hinaus; sie liegt eher in Höhe der Abdeckung 11. An diesen Vorsprung schließt sich ein Bund 40 an, der eine Dichtung 45 abstützt, die in einer inneren Einsenkung 46 der Abdeckung liegt und den Durchbruch mit eingesetztem Lichtleiter abdichtet. An den Bund schließt sich ein längerer Schaft 47 des Lichtleiters an, der seitliche Rastelemente 41 in Form von sägezahnartigen Nasen trägt, die mit entsprechenden, ebenfalls Rastelemente 42 bildenden Ausschnitten an der Ummantelung 24 bzw. diese verlängernden Laschen 48 nach Art eines Schnappverschlusses zusammenwirken. Über die Rastelemente 41 ragt der in diesem Bereich kreisrunde Schacht hinaus und endet in der Stirnfläche 30,' die die Lichteintrittsfläche für das Licht aus der Leuchtdiode 29 ist, über der sie angeordnet ist.

Die Figur 8 zeigt die flache, gebogene Form des glasklaren Leuchtelementes 15 mit seitlichen Führungsrippen 49. Die Ummantelung 24 ist der Form des Leucht-Elementes 15 angepasst. Wegen ihrer genauen Form wird auf Figur 8 hingewiesen. Sie ist an die Abdeckung 11 angeformt, könnte aber auch dicht mit ihr verbunden sein und umgibt das Leucht-Element 15 mit einem relativ großem Luftspalt 53. Sie ist ununterbrochen bis vor die die Rastelemente 42 bildenden Durchbrüche, an denen die Laschen 48 beginnen. Diese sind so ausgebildet, dass sie beim Einstecken des Leuchtelementes (in der Zeichnung von links nach rechts) etwas auseinander federn und somit den Schnappverschluss bilden.

Das flexible, elektrisch leitende Sensor-Element 44 hat die Grundform eines Kreiszylinders, ist jedoch an einer Stelle mit einer kreisringsegmentförmigen Ausnehmung 55 ausgebildet, die zur Außenform der Ummantelung in diesem Bereich passt. Somit schließt das Sensor-Element 44 unmittelbar an diese Ummantelung an, die auch ein Teil ihrer Befestigungshalterungen bildet. Die übrigen Halterungen werden durch Rippen 56 gebildet, die an die Abdeckung 11 angeformt sind. Das Sensor-Element kann also von links her zwischen diese Halterungen eingesteckt werden, die sich infolge der Elastizität etwas in die Oberfläche eingraben und damit das Sensor-Element an die Unterseite des Schalterbereiches 12 angedrückt festhalten. Die andere Stirnfläche 26 des Sensor-Elementes 44 liegt auf der Kontaktfläche 27.

Auch hier schirmt also die Ummantelung 42 das Leuchtelement 15 bzw. den Innenkanal 52 darin gegen eine Unterschreitung der Luft- und Kriechstrecke von spannungsführenden Teilen zur berührbaren Oberfläche hinab. Gleichzeitig hat diese Ausbildung auch noch eine Funktion in Verbindung mit der Halterung und Festlegung des Sensor-Elementes.

## Patentansprüche

1. Bedieneinrichtung zur Bedienung eines Elektrogerätes, vorzugsweise eines Haushaltsgerätes, wie eines Wäschetrockners, mit einem Sensor-Element (44) eines Näherungs- oder Berührungsschalters, wobei das Sensorelement aus flexiblem, elektrisch leitfähigem Material besteht und an einer Abdeckung (11) als Berührfläche angeordnet ist und dort einen Schaltbereich (12) bildet, wobei das Sensor-Element (44) an einer mit elektrischen Leitern (27) versehenen Auflage (28), beispielsweise einer Leiterplatte, angeordnet ist, und mit einem Leucht-Element in oder in der Nähe des Schaltbereichs (12), **gekennzeichnet durch** ein Leucht-Element (15), das **durch** einen Durchbruch (16) der Abdeckung (11) hindurchragt und **durch** eine elektrische isolierende Ummantelung (23) mindestens eines der Elemente (15, 44) zur Schaffung einer Luft- und Kriechstrecke.

2. Bedieneinrichtung nach Anspruch 1, **dadurch gekennzeichnet, dass** das Leucht-Element nach Art eines Lichtleiters von einem Lichterzeuger (29), wie einer Diode, beleuchtet ist, die vorzugsweise an der Auflage (28), z.B. einer Leiterplatte, angeordnet ist.

3. Bedieneinrichtung nach Anspruch 1 oder 2, **dadurch gekennzeichnet, dass** das Sensor-Element (44) zweiteilig mit einem die Abdeckung (11) kontaktierenden Teil (25) und einem einen Leiter (27) an der Auflage (28) kontaktierenden Teil (24) ausgebildet ist und dass zwischen den Teilen (24, 25) eine elektrische Isolation vorgesehen ist.

4. Bedieneinrichtung nach Anspruch 2 oder 3, **dadurch gekennzeichnet, dass** das Leucht-Element (15) durch das Sensor-Element, vorzugsweise seinen abdeckungsnahen Teil (25), hindurchragt und der von dem Sensor-Element kontaktierte Schaltbereich (12) auf der Berührfläche das Leucht-Element (15) umgibt.

5. Bedieneinrichtung nach einem der Ansprüche 2 bis 4, **dadurch gekennzeichnet, dass** das Sensor-Element (44), vorzugsweise sein abdeckungsnaher Teil (25), als Dichtung für den Durchbruch (16) ausgebildet ist.

6. Bedieneinrichtung nach einem der Ansprüche 3 bis 5, **gekennzeichnet durch** ein Aufnahmeelement (18), das eine zur Ummantelung (23) gehörende, vorzugsweise topfförmige Aufnahme (20) für den auflagenahen Teil (24) des Sensor-Elements (44), einen die Isolation bildenden Boden (21) und eine vorzugsweise schalenförmige Aufnahme (22) für den abdeckungsnahen Teil (25) des Sensorelementes aufweist, wobei vorzugsweise die Aufnahme (22) für den abdeckungsnahen Teil (25) einen größeren Durchmesser hat als die Aufnahme (20) für den auflagenahen Teil (24).

7. Bedieneinrichtung nach Anspruch 5 oder 6, **dadurch gekennzeichnet, dass** das Aufnahmeelement (18) einen Lichtleiter bildet und an seiner auflagenseitigen Stirnfläche von einer Leuchtdiode (LED) (29) beleuchtbar ist, wobei insbesondere das Leucht-Element (15) als ein gegebenenfalls exzentrisch zum Schaltbereich (12) angeordneter Vorsprung (17) durch die abdeckungsnahe Aufnahme (22) hindurch und in den Durchbruch (16) der Abdeckung (11) hineinragt und vorzugsweise der Vorsprung in Verlängerung der Aufnahme des auflagenahen Teils des Sensorelements ausgebildet ist.

8. Bedieneinrichtung nach einem der vorhergehenden Ansprüche, **dadurch gekennzeichnet, dass** die Luft- und Kriechstrecke für elektrische Spannung zwischen dem Durchbruch (16) und dem auflagenahen Ende (30) der Ummantelung (23) von mindestens 12mm beträgt.

9. Bedieneinrichtung nach einem der Ansprüche 6 bis 8, **gekennzeichnet durch** einen eine Tropfnase bildenden Vorsprung (31) am Aufnahmeelement (18), vorzugsweise in äußerer Verlängerung des Bodens (21).

10. Bedieneinrichtung nach einem der vorhergehenden Ansprüche, **dadurch gekennzeichnet, dass** die an der Abdeckung (11) anliegende, die wirksame Größe des Schaltbereichs (12) bestimmende Stirnfläche (32) des Sensor-Elements (44) größer ist als die an der Auflage anliegende Stirnfläche (26) des Sensorelements.

11. Bedieneinrichtung nach einem der vorhergehenden Ansprüche, **dadurch gekennzeichnet, dass** die Ummantelung (23) des Leucht-Elementes (15) den Durchbruch (16) unmittelbar umgibt und vorzugsweise an die Abdeckung (11) angeformt ist.

12. Bedieneinrichtung nach Anspruch 11, **dadurch gekennzeichnet, dass** die Ummantelung ein rohrförmiges Teil bildet, das von dem Sensor-Element umgeben ist und vorzugsweise dieses trägt, wobei das Leucht-Element in die rohrförmige Ummantelung eingesetzt ist, insbesondere nach Art eines darin abgedichteten Stiftes mit einem eine Leuchtfläche (14) bildenden Kopf.

13. Bedieneinrichtung nach Anspruch 11, **dadurch gekennzeichnet, dass** die Ummantelung angrenzend an das Sensor-Element (44) angeordnet ist und ggf. eine an einem Teil der Außenfläche des Sensor-Elementes (44) äußere Haltefläche für das Sensor-Element (44) bildet.

14. Bedieneinrichtung nach Anspruch 13, **dadurch gekennzeichnet, dass** das Leucht-Element (15) Rastelemente (41) aufweist, die mit Rastelementen (42) an der Ummantelung (23) zusammenwirken.

15. Bedieneinrichtung nach Anspruch 13 oder 14, **dadurch gekennzeichnet, dass** der Durchbruch (16) und ggf. das Leucht-Element (15) vorzugsweise Kreisringsegmentform hat und im Randbereich des Schaltbereichs (12) liegt, wobei die Ummantelung (23) ein einen Randausschnitt (43) des Sensor-Elements (44) eingreift.

16. Bedieneinrichtung nach einem der vorhergehenden Ansprüche, **dadurch gekennzeichnet, dass** das zwischen dem Leucht-Element (15) und der Ummantelung (23) ein Luftspalt gebildet ist.

## Claims

1. Operating device for operating an electrical appliance, preferably a domestic appliance, such as a laundry dryer, having a sensor element (44) of a touch or proximity switch, the sensor element being made from flexible, electrically conductive material and positioned on a cover (11) as the touch contact face and forming there a switching area (12), the sensor element (44) being placed on a support (28) provided with electrical conductors (27) and e.g. a printed circuit board and with a light emitting element in or in the vicinity of the switching area (12) **characterized by** a light emitting element (15) projecting through an opening (16) of cover (11) and by an electrically insulating envelope (23) of at least one of the elements (15, 44) for creating an air and leakage path.

2. Operating device according to claim 1, **characterized in that** the light emitting element in the manner of a light guide is illuminated by a light generator (29), such as a diode, which is preferably placed on the support (28), e.g. a printed circuit board.

3. Operating device according to claim 1 or 2, **characterized in that** the sensor element (44) is constructed in two parts with one part (25) contacting the cover (11) and another part (24) contacting a conductor (27) on support (28) and that between the two parts (24, 25) an electrical insulation is provided.

4. Operating device according to claim 2 or 3, **characterized in that** the light emitting element (15) projects through the sensor element, preferably its cover-near part (25) and surrounds the switching area (12) on the contact face of light emitting element (15) contacted by the sensor element.

5. Operating device according to one of the claims 2 to 4, **characterized in that** the sensor element (44), preferably its cover-near part (25), is constructed as a seal for the opening (16).

6. Operating device according to one of the claims 3 to 5, **characterized by** a reception element (18) which has a preferably cup-shaped receptacle (20) belonging to the envelope (23) for the support-near part (24) of sensor element (44), an insulation-forming bottom (21) and a preferably shell-shaped receptacle (22) for the cover-near part (25) of the sensor element, the receptacle (22) for the cover-near part (25) preferably having a larger diameter than the receptacle (20) for the support-near part (24).

7. Operating device according to claims 5 or 6, **characterized in that** the reception element (18) forms a light guide and on its support-side end face is illuminatable by a light emitting diode (LED) (29) and in particular the light emitting element (15) is constructed as a projection (17) optionally eccentric to the switching area (12) and passing through the cover-near receptacle (22) and into the opening (16) of cover (11), the projection preferably being constructed in the extension of the receptacle of the support-near part of the sensor element.

8. Operating device according to one of the preceding claims, **characterized in that** the air and leakage path for an electric voltage between the opening (16) and the support-near end (30) of envelope (23) is at least 12 mm.

9. Operating device according to one of the claims 6 to 8, **characterized by** a projection (31) on reception element (18), preferably in the outer extension of bottom (21), forming a dripping projection.

10. Operating device according to one of the preceding claims, **characterized in that** the end face (32) of sensor element (44) determining the effective size of the switching area (12) and engaging on cover (11) is larger than the sensor element end face (26) engaging on the support.

11. Operating device according to one of the preceding claims, **characterized in that** the envelope (23) of light emitting element (15) directly surrounds opening (16) and is preferably shaped onto cover (11).

12. Operating device according to claim 11, **characterized in that** the envelope forms a tubular part, which is surrounded by the sensor element and preferably carries the same, the light emitting element being inserted in the tubular envelope, particularly in the manner of a pin sealed therein with a head forming the light emitting face (14).

13. Operating device according to claim 11, **characterized in that** the envelope is located adjacent to the sensor element (44) and optionally forms an outer retaining face for the sensor element (44) located on part of the outer face of said sensor element (44).

14. Operating device according to claim 13, **characterized in that** the light emitting element (15) has latching elements (41) cooperating with latching elements (42) on envelope (23).

15. Operating device according to claim 13 or 14, **characterized in that** the opening (16) and optionally the light emitting element (15) are preferably circular segmental and is located in the marginal region of switching area (12), envelope (23) engaging in a marginal cutout (43) of sensor element (44).

16. Operating device according to one of the preceding claims, **characterized in that** an air gap is formed between light emitting element (15) and envelope (23).

## Revendications

1. Dispositif de service pour la commande d'un appareil électrique, de préférence un appareil ménager, comme un sèche-linge, avec un élément détecteur (44) d'un commutateur de proximité ou d'une touche à effleurement, où l'élément détecteur est constitué d'un matériau flexible et électriquement conductible et disposé auprès d'un recouvrement (11) qui est utilisé en tant que surface de contact, en y constituant un domaine pour l'opération de commutation (12), sachant que l'élément détecteur (44) est disposé sur un appui (28) muni de conducteurs électriques (27), par exemple un circuit imprimé, et avec un élément lumineux dans le domaine de commutation (12) ou à proximité de celui-ci, **caractérisé par** un élément lumineux (15), qui saille à travers un passage (16) du recouvrement (11) et par le revêtement (23) électriquement isolant d'au moins un des éléments (15, 44) pour créer une distance d'isolation et une ligne de fuite.

2. Dispositif de service d'après la revendication 1, **caractérisé en ce que** l'élément lumineux est illuminé, à la manière d'un guide de lumière, par une source lumineuse (29), comme une diode, laquelle est disposée de préférence auprès de l'appui (28), par exemple auprès d'un circuit imprimé.

3. Dispositif de service d'après la revendication 1 ou 2, **caractérisé en ce que** l'élément détecteur (44) est réalisé en deux pièces avec une pièce (25) qui crée le contact avec le recouvrement (11) et une pièce (24), qui crée le contact avec le conducteur (27) auprès de l'appui (28) et **en ce que** entre les pièces (24, 25) est prévue une isolation électrique.

4. Dispositif de service d'après la revendication 2 ou 3, **caractérisé en ce que** l'élément lumineux (15) saille à travers l'élément détecteur, de préférence à travers sa pièce (25) situé à proximité du recouvrement et que le domaine de commutation (12) branché par l'élément détecteur entoure l'élément lumineux (15) sur la surface de contact.

5. Dispositif de service d'après une des revendications de 2 à 4, **caractérisé en ce que** l'élément détecteur (44) et de préférence sa pièce (25) située à proximité du recouvrement, est réalisée en tant que joint d'étanchéité pour le passage (16).

6. Dispositif de service d'après une des revendications de 3 à 5, **caractérisé par** un élément de logement (18), qui présente un logement (20) de préférence en forme de cuvette et appartenant au revêtement (23), pour la pièce (24) de l'élément détecteur (44) située à proximité de l'appui, et un fond (21) constituant l'isolation, et un logement (22) pour la pièce (25) de l'élément détecteur à proximité du recouvrement, sachant que de préférence le logement (22) pour la pièce (25) à proximité du recouvrement présente un diamètre plus grand que le logement (20) pour la pièce (24) à proximité de l'appui.

7. Dispositif de service d'après la revendication 5 ou 6, **caractérisé en ce que** l'élément de logement (18) forme un guide de lumière et qu'il peut être éclairé par une diode électroluminescente (DEL) (29) à sa surface frontale du côté de l'appui, sachant que notamment l'élément lumineux (15) saille en tant que saillie (17) disposée éventuellement de manière excentrique par rapport au domaine de commutation (12) à travers le logement (22) proche du recouvrement à l'intérieur du passage (16) du recouvrement (11) et que la saillie est réalisée de préférence en tant que prolongement du logement de la pièce de l'élément de détecteur située à proximité de l'appui.

8. Dispositif de service d'après une des revendications précédentes, **caractérisé en ce que** la distance d'isolation et la ligne de fuite pour un courant électrique entre le passage (16) et l'extrémité (30) du revêtement (23) située à proximité de l'appui comporte au moins 12 mm.

9. Dispositif de service d'après une des revendications de 6 à 8, **caractérisé par** une saillie (31) formant un rejetteau sur l'élément de logement (18) de préférence en tant que prolongement du fond (21).

10. Dispositif de service d'après une des revendications précédentes, **caractérisé en ce que** la surface frontale (32) de l'élément détecteur (44) adjacente au recouvrement (11) et déterminant la dimension effective du domaine de commutation (12) est supérieure à celle de la surface frontale (26) de l'élément détecteur adjacente à l'appui.

11. Dispositif de service d'après une des revendications précédentes, **caractérisé en ce que** le revêtement (23) de l'élément lumineux (15) entoure directement le passage (16) et que de préférence il est ajouté par moulage au recouvrement (11).

12. Dispositif de service d'après la revendication 11, **caractérisé en ce que** le revêtement forme un élément tubulaire, qui est entouré par l'élément détecteur et le porte de préférence, sachant que l'élément lumineux est inséré dans le revêtement tubulaire, notamment à la manière d'une tige étanchée dans ce revêtement avec une tête qui constitue la surface lumineuse (14).

13. Dispositif de service d'après la revendication 11, **caractérisé en ce que** le revêtement est disposé de manière adjacente à l'élément détecteur (44) et qu'il forme éventuellement une surface de support extérieure pour l'élément détecteur (44) pour une partie de la surface extérieure de l'élément détecteur (44).

14. Dispositif de service d'après la revendication 13, **caractérisé en ce que** l'élément lumineux (15) présente des éléments à enclenchement (41) qui agissent conjointement avec des éléments à enclenchement (42) du revêtement (23).

15. Dispositif de service d'après la revendication 13 ou 14, **caractérisé en ce que** le passage (16) et éventuellement l'élément lumineux (15) présente de préférence une forme de segment d'anneau de cercle et se trouve dans la zone marginale du domaine de commutation (12), sachant que le revêtement (23) s'engage dans un secteur marginal (43) de l'élément détecteur (44).

16. Dispositif de service d'après une des revendications précédentes, **caractérisé en ce qu'**entre l'élément lumineux (15) et le revêtement (23) est formé un interstice.
